# EUROPEAN PATENT APPLICATION

(11) **EP 1 280 189 A1**
(43) Date of publication of application: **29.01.2003**
(21) Application number: 01401908.7
(22) Date of filing: 16.07.2001
(51) Int. Cl.: H01L 21/20, H01L 21/331

(54) **Process for selective epitaxial growth and bipolar transistor made by using such process**

(71) Applicant: ALCATEL, 75008 Paris (FR)
(72) Inventor: Chevalier, Pascal Guy Yves, 59250 Halluin (FR); De Pestel, Freddy Marcel Yvan, 9080 Lochristi (BE); Ackaert, Jan, 9700 Oudenaarde (BE); Vastmans, Johan, 9000 Gent (BE)
(74) Representative: Narmon, Gisèle Marie Thérèse

(57) **Abstract**

The invention relates to a process for the selective epitaxial growth of a Si containing layer (8) on a substrate (1), characterised in that the substrate (1) is provided with a layer (4) of silicon oxynitride with an atomic concentration of oxygen between 30 and 45% and an atomic concentration of nitrogen between 19 and 35% before the selective epitaxial growth of the Si containing layer (8).

## Description

The present invention relates to a process for the selective epitaxial growth or deposition of a Si containing film or layer on a substrate.

More specifically, the invention relates to get selective epitaxial growth of a Si and/or SiGe film or layer on a Si containing substrate with a patterned layer having a low etch rate in an HF (hydro fluoric acid) solution, a low stress (wafer is nearly entirely covered by this masking layer) while allowing a high process throughput.

For the inter poly dielectric patterned layer in a bipolar module for example, a film or layer is needed with an etch rate during the opening of the intrinsic base region as low as possible and a good selective behaviour towards Si or SiGe deposition in the emitter window. In addition the layer needs to have a low stress to avoid delamination.

Up to now the deposit of the SiGe layer is made on a Si substrate provided with a Silicon Nitride layer (Si₃N₄) for defining the pattern or zone where a SiGe layer has to be deposited. Such a deposit is disclosed in US patent No. 5.506.427, the content of which is incorporated in the present specification by reference.

The main problem with Si₃N₄ is that the layer does not allow to develop a selective epitaxial process with a sufficient growth rate for being acceptable in manufacturing conditions. Nitride has moreover a low etchrate and high stress.

The invention relates thus to a process for the selective epitaxial growth of a Si containing layer on a substrate, which is characterised in that the substrate is provided with a layer of silicon oxynitride with an atomic concentration of oxygen between 30 and 45% and an atomic concentration of nitrogen between 19 and 35% before the selective epitaxial growth of the Si containing layer, said growth taking selectively place there where the substrate is not covered by the oxynitride layer.

It has now been discovered that by using a specific layer, namely a silicon oxynitride interpoly dielectric layer, it was possible to increase drastically the epitaxial growth rate of a Si or SiGe film or layer on the substrate there where this substrate is free of oxyntride layer, for instance where the oxynitride layer has been etched away.

With such a composition of the oxynitride, it is possible to obtain an oxynitride layer with a maximal stress of 200 Mpa and an etch rate ratio between the oxynitride layer and TEOS of at least 5 : 1 in a solution containing buffered HF.

The use of silicon oxynitride layers in the fabrication of semiconductor devices is mentioned in US patent No. 5.998.273, but neither their composition nor the way they are deposited, is described. Any inherent capability for higher Si epitaxial growth rate is not mentioned.

It was found that with certain oxynitride compositions, with oxygen and/or nitrogen contents outside the above mentioned ranges, either the stress in the layer is unacceptably high, resulting in peeling off of the underlying poly, or either a bad HF etching behaviour is obtained.

According to the invention, the atomic concentration of nitrogen of the oxynitride is preferably comprised between 29 and 30%, while the atomic concentration of oxygen is about 35-37%.

The oxynitride layer is preferably formed by plasma enhanced chemical vapour deposition (PECVD).

According to a detail of the process of the invention, the oxynitride layer forms a masking or patterned layer before the growth or deposit of the Si containing film or layer.

The masking layer is advantageously formed of a oxynitride layer with openings provided with silicon nitride edges at the places where the Si containing layer has to be deposited.

Preferably, the oxynitride layer has a composition suitable to withstand oxide etch in a NH₄/HF solution with a molar ratio NH₄/HF of 7:1.

The Si containing layer may be a Si or SiGe layer.

The oxynitride layer is advantageously densified with an anneal for decreasing its etch rate in HF solution.

The invention relates also to a bipolar transistor, comprising a Si containing substrate and a selectively epitaxial grown Si containing layer, particularly a Si or SiGe layer, said transistor having the improvement that the Si containing substrate is provided with an interpoly dielectric patterned layer of silicon oxynitride with an atomic concentration of oxygen between 30 and 45% and an atomic concentration of nitrogen between 19 and 35%.

Preferably, the oxynitride layer is a layer obtained by plasma enhanced chemical vapour deposition (PECVD).

According to an embodiment of the invention, the oxynitride layer has a composition suitable to withstand oxide etch in a NH₄/HF solution with a molar ratio NH₄/HF of 7:1.

Preferably, the atomic concentration of nitrogen of the oxynitride layer is comprised between 29 and 30%, while the atomic concentration of oxygen is about 35%-37%.

Advantageously, the selectively grown Si containing layer is a Si or SiGe layer and is epitaxially grown at a small distance from the oxynitride layer.

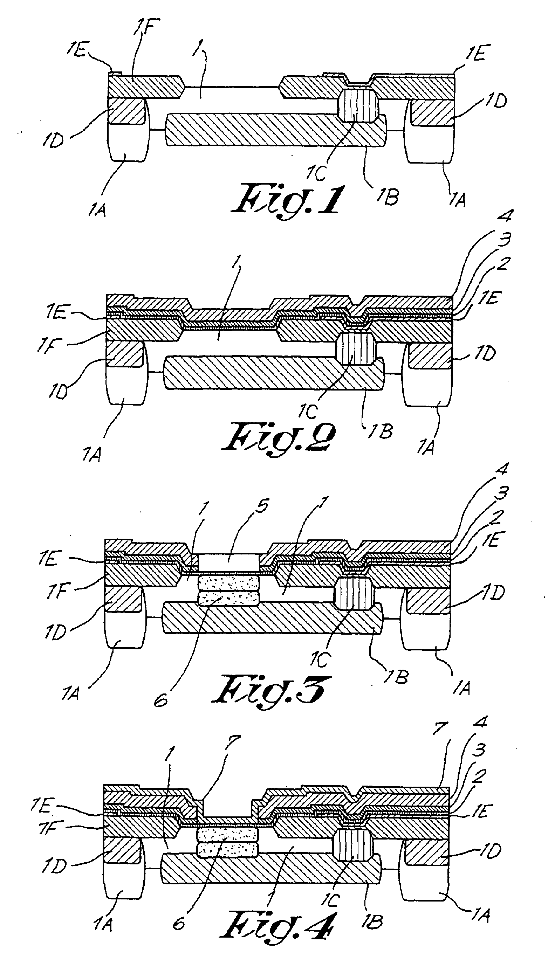

The invention will be made more clear in the following description of an example of a method for manufacturing a bipolar transistor, including the process for selective epitaxial growth of the invention, referring to the attached drawings wherein figures 1 to 10 show a portion of the bipolar transistor during successive steps of its manufacturing.

On a silicon containing surface 1, (for example associated to buried layer P [1A], buried layer N [1B], sinker [1C), p-well [1D), nitride layer [1E], field oxide [1F]), an oxide layer 2 (such as TEOS) is deposited and densified.

Thereafter a polysilicon base layer 3 is deposited. On said polybase layer 3, a silicon oxynitride layer 4 is formed by plasma enhanced chemical vapour deposition (PECVD).

The oxynitride layer 4 is then densified. A 30 min densification on 850°C in N₂ ambient for example proved to achieve a low etchrate.

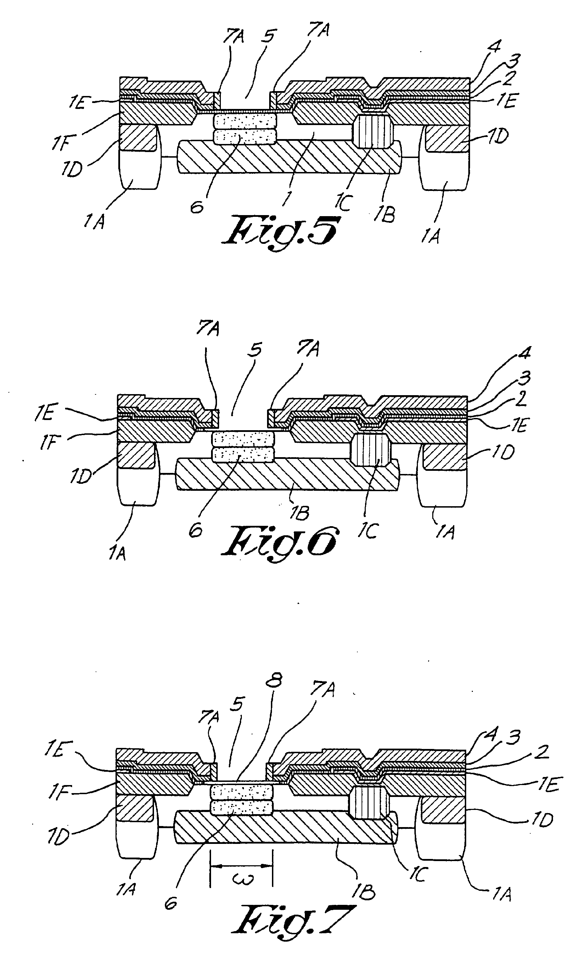

The situation shown in figure 2 is obtained.

Advantageously, the composition of the silicon oxynitride layer 4 is selected so as to avoid the peeling off of the underlying layers.

Preferably, the oxynitride used has the following atomic concentration: atomic oxygen between 30 and 45%, atomic nitrogen between 19 and 35%.

The N/Si ratio is for example between 0,6 and 1 and the O/Si ratio between 0,85 and 1,4.

The oxygen concentration and the nitrogen concentration are complementary and cannot be changed independently from each other.

Advantageously, the atomic concentration of oxygen is about 35-37% and the atomic concentration of nitrogen is about 29-30%.

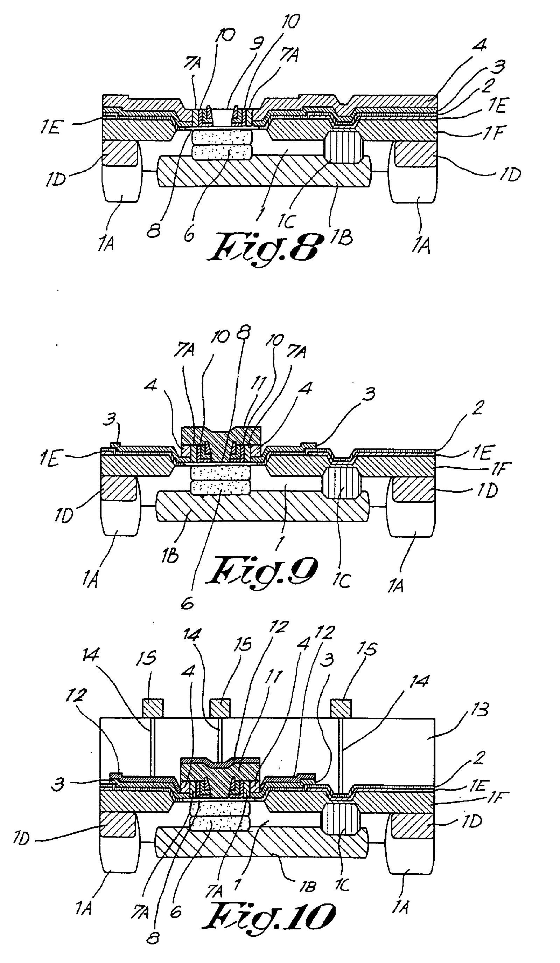

An emitter window 5 is then formed in the layer stack by means of a dry etch, said window being 5 stopped at the oxide (TEOS) layer 2 as shown in figure 3.

Selectively implanted collector 6 reduces the collector resistance.

A nitride layer 7 is then deposited on the wafer or layer stack with the window 5 (figure 4).

This nitride layer 7 is dry etched, which leads to the formation of a sidewall 7A of the emitter window 5 (figure 5).

An oxide wet etching, performed in buffered HF solution will open the intrinsic base region under the polysilicon base layer 3. The oxide (TEOS- which is the abbreviation of tetra ethyl ortho silicate) layer 2 in the emitter window 5 is exposed and advantageously removed so as to form free space for later SiGe/Si base 8 growth in direct contact with the polysilicon base layer 3. The situation shown in figure 6 is obtained after etching the oxide.

The oxide undercut has to be sufficient to permit a good link between intrinsic base 8 (SiGe base) and layer 3 (extrinsic polysilicon base).

During these two etching steps, the capping material (oxynitride layer 4) is also exposed but the oxynitride removal is reduced to a minimum. The side walls 7A of the emitter window 5 withstand said etching as shown in figure 6. The loss of layer 4 is limited so that the nitride walls 7A do practically not stick out above the layer 4.

The emitter window 5 is consequently provided with nitride wall 7A or spacer protecting the polysilicon base layer 3 during the epitaxial growth. Indeed aim of selective growth is to deposit a monocrystalline layer but growth occurs also on polysilicon surface in case they are not protected.

Monocrystalline SiGe/Si intrinsic base 8 is then selectively deposited (figure 7).

The silicon oxynitride layer 4 withstanding an HF etching acts as a masking layer for the manufacture of a fully-self aligned SiGe layer 8, and thus a fully self-aligned SiGe heterojunction bipolar transistor. SiGe will not deposit on the silicon oxynitride.

The emitter window 5 has a width "w" which can be adapted, and further decreased with one or more inside spacers 10 to obtain a resulting emitter opening 9 as shown in figure 8. In this figure 3 of these spacers are shown. However in other embodiments this number may vary.

Then polysilicon 11 is deposited. The product is then further dry etched such as to remove the oxynitride layer 4 not covered by the polysilicon deposit 11. Also a portion of the polysilicon base 3 is removed later (figure 9).

A silicidation 12 is then performed followed by the placement of an interlayer dielectric 13, plug 14 and metal deposit 15. The result is shown in figure 10.

Tests have been carried out (test 1) with a silicon oxynitride layer 4 covering the polysilicon layer 3 (as masking layer as shown in the figures), said oxynitride layer 4 having the following atomic concentration: 29,5% Nitrogen, 36% Oxygen and 34,5% Silicon, and (test 2) with a nitride layer as masking layer replacing the oxynitride layer.

Said tests have shown that the chemical vapour deposition growth of Si was increased by a factor 5 when using the SiₓO_{y}N_{z} layer (test 1) with respect to the growth when using only a silicon nitride layer (test 2).

The chemical vapour deposition growth of SiGe was even increased by a factor 10 when using the silicon oxynitride layer 4 with respect to the growth when using only a silicon nitride layer as masking layer (test 2).

While the principles of the invention have been described above in connection with specific embodiments, it is to be clearly understood that this description is made only by way of example and not as a limitation on the scope of the invention.

## Claims

1. Process for the selective epitaxial growth of a Si containing layer (8) on a substrate (1), **characterised in that** the substrate (1) is provided with a layer (4) of silicon oxynitride with an atomic concentration of oxygen between 30 and 45% and an atomic concentration of nitrogen between 19 and 35% before the selective epitaxial growth of the Si containing layer (8), said growth taking selectively place there where the substrate (1) is not covered by the oxynitride layer (4).

2. The process of claim 1, **characterised in that** the atomic concentration of nitrogen of the oxynitride is preferably comprised between 29 and 30%, while the atomic concentration of oxygen is about 35-37%.

3. The process of claim 1 or 2, **characterised in that** the oxynitride layer (4) is preferably formed by plasma enhanced chemical vapour deposition (PECVD).

4. The process of any one of claims 1 to 3, **characterised in that** the oxynitride layer (4) forms a masking or patterned layer before the growth of the Si containing layer (8) on not masked portion(s) of the substrate (1).

5. The process of claim 4, **characterised in that** the patterned layer is formed of an oxynitride layer (4) with at least one opening (5) provided with silicon nitride edges (8A) at the places where the Si containing layer (8) has to be deposited.

6. The process of claim 4 or 5, **characterised in that** the masking layer (4) covers a polysilicon base layer (3) deposited on the substrate (1) possibly provided with an oxide layer (2).

7. The process of any one of the preceding claims, **characterised in that** the oxynitride layer has a composition suitable to withstand oxide etch in a NH₄/HF solution with a molar ratio NH₄/HF of 7:1.

8. The process of any one of the preceding claims, **characterised in that** the Si containing layer (8) which is grown is a Si or SiGe layer.

9. The process of any one of the preceding claims, **characterised in that** the Si containing layer (8) is grown at a small distance from the oxynitride layer (4).

10. The process of any one of the preceding claims, **characterised in that** the substrate (1) is a Si containing substrate.

11. The process according to any one of the preceding claims, **characterised in that** the oxynitride layer (4) is densified with an anneal for decreasing its etch rate in HF solution.

12. A bipolar transistor, comprising a Si containing substrate (1) and a selectively epitaxial grown Si or SiGe layer (8), **characterised in that** the Si containing substrate (1) is provided with an interpoly dielectric patterned layer (4) of silicon oxynitride with an atomic concentration of oxygen between 30 and 45% and an atomic concentration of nitrogen between 19 and 35%.

13. The bipolar transistor of claim 12, **characterised in that** the oxynitride layer (4) has a composition suitable to withstand oxide etch in a NH₄/HF solution with a molar ratio NH₄/HF of 7:1.

14. The bipolar transistor of claim 12, **characterised in that** the oxynitride layer (4) has an atomic concentration of nitrogen comprised between 29 and 30%, while the atomic concentration of oxygen is about 35%-37%.
